## Europäisches Patentamt
## European Patent Office
## Office européen des brevets

(19)

(11) Numéro de publication: **0 009 438**
**B1**

(12) **FASCICULE DE BREVET EUROPEEN**

(45) Date de publication du fascicule du brevet: **21.09.83**

(21) Numéro de dépôt: **79400633.8**

(22) Date de dépôt: **10.09.79**

(51) Int. Cl.³: **G 11 C 11/34,**
**G 11 C 19/28,**
**H 01 L 27/10, H 03 K 21/36**

(54) **Elément de mémoire dynamique à transfert de charges, et application notamment à un registre à décalage.**

(30) Priorité: **15.09.78 FR 7826552**

(43) Date de publication de la demande:
**02.04.80 Bulletin 80/7**

(45) Mention de la délivrance du brevet:
**21.09.83 Bulletin 83/38**

(84) Etats contractants désignés:
**DE GB NL**

(73) Titulaire: **THOMSON-CSF**
**173, Boulevard Haussmann**
**F-75379 Paris Cedex 08 (FR)**

(72) Inventeur: **Berger, Jean-Luc**
**Thomson-CSF - SCPI 173, bld Haussmann**
**F-75360 Paris Cedex (FR)**

(74) Mandataire: **Benoit, Monique et al,**
**THOMSON-CSF SCPI 173, Bld Haussmann**
**F-75379 Paris Cedex 08 (FR)**

(56) Documents cités:
US - A - 3 760 202
US - A - 3 763 480
US - A - 3 789 247
US - A - 3 838 438
US - A - 3 953 745
US - A - 3 967 254
US - A - 3 980 902
US - A - 3 986 176
US - A - 4 010 485
US - A - 4 015 247
US - A - 4 038 565
US - A - 4 103 343

(56) Documents cités:
IEEE JOURNAL OF SOLID-STATE CIRCUITS vol.
SC11, no. 5, Octobre 1976, New York (US),
FAGAN et al.: "A 16-Kbit non-volatile charge
addressed memory", pages 631—636.
IEEE JOURNAL OF SOLID-STATE CIRCUITS vol.
SC8, no. 5, octobre 1973 New York (US), CHAN
et al.: "A CCD Serial to Parallel Shift Register",
pages 388—391.
IBM TECHNICAL DISCLOSURE BULLETIN, vol.
18, no. 2, juillet 1975 Armonk (US), PATRIN:
"Fast Access Low Power Charge Transfer
Device for High Performance Memory", pages
343—344.

Courier Press, Leamington Spa, England.

IEEE JOURNAL OF SOLID-STATE CIRCUITS vol. SC11, no. 1, février 1976 New York (US), CHOU: "Design of a 16,384-bit serial charge coupled memory device" pages 10—18.
IEEE JOURNAL OF SOLID-STATE CIRCUITS vol. SC-11, no. 1, février 1976 New York (US), VARSHNEY et al.: "A Byte Organized NMOS-CCD Memory with Dynamic Refresh Logic", pages 18—24.
IEEE JOURNAL OF SOLID-STATE CIRCUITS vol. SC11, no. 1, février 1976, New York (US), TASCH et al.: "The charge-coupled RAM cell concept", pages 58—63.
IEEE JOURNAL OF SOLID-STATE CIRCUITS vol. SC11, no. 1, février 1976, New York (US), ROBERTS et al.: "A processor for pulsedoppler radar", pages 100—104.

Element de memoire dynamique a transfert de charges, et application notamment a un
registre a decalage

La présente invention a pour objet un élément de mémoire dynamique utilisant le transfert de charges électriques dans un milieu semiconducteur. Elle a également pour objet l'application de cet élément de mémoire notamment à un registre à décalage, ou à un diviseur de fréquence.

Différentes méthodes sont connues pour réaliser des éléments de mémoire, notamment de mémoire dynamique, c'est-à-dire pour lesquelles il est nécessaire de procéder périodiquement à la régénération du signal mémorisé.

Parmi les réalisations connues, on peut citer celle qui est décrite dans un article de SUNLIN CHOU: "Design of a 16,384-bit serial charge coupled memory device" (IEEE JOURNAL OF SOLID-STATE CIRCUITS, vol. SC11, n° 1, février 1976); il s'agit d'un ensemble de boucles de recirculation, chacune étant constituée par quatre canaux à transfert de charges parcourus deux à deux en sens opposé, les charges passant d'un canal à l'autre par l'intermédiaire d'un dispositif régénérateur et inverseur; ce dispositif comporte donc de nombreux canaux de transfert de charges et une circuiterie assez complexe autour, ce qui le rend peu adapté à certaines applications.

On connaît également (article de CHAN et CHAMBERLAIN; "A CCD Serial to Parallel Shift Register", paru dans IEEE JOURNAL OF SOLID-STATE CIRCUITS, vol. SC8, n° 5, octobre 1973) un registre à décalage à transfert de charges dans lequel peuvent être obtenues des sorties en parallèle au niveau de chacun des étages du registre; toutefois, ce registre n'accomplit aucune fonction de mémorisation.

On connaît encore (brevet américain n° 4 103 343) un dispositif de mémorisation comportant une pluralité de cellules à transfert de charges; dans chaque cellule, l'information est mémorisée par transferts alternatifs sous une première électrode de la cellule puis sous une deuxième, et réciproquement; cette disposition présente l'inconvénient de n'avoir pas de régénération de l'information et conduit normalement à la dégradation de cette dernière.

On connaît aussi (article de FAGAN, WHITE et LAMPE: "A 16-Kbit non-volatile charge addressed memory", paru dans IEEE JOURNAL OF SOLID-STATE CIRCUITS, vol. SC11, n° 5, octobre 1976) une structure de mémoire utilisant un registre à décalage à transfert de charges (de type CCD), à chacun des étages duquel est associée une cellule mémoire non volatile du type MNOS; cette solution présente notamment l'inconvénient de faire appel à deux technologies distinctes.

Il a également été proposé (brevet américain n° 3 986 176) d'associer à chaque étage d'un registre à décalage à transfert de charges (CCD ou BBD) une cellule mémoire à base de capacités et de transistors dans laquelle l'information est stockée statiquement et temporairement.

Enfin, le brevet américain n° 4 038 565 illustre l'utilisation d'un registre à décalage DTC à la réalisation d'un diviseur de fréquence, mais ne comporte pas de mémorisation.

La présente invention a pour but de constituer un élément de mémoire dynamique à partir d'un dispositif à transfert de charges (ou DTC), de structure simple et présentant les avantages inhérents aux DTC, c'est-à-dire réalisation simple et faible consommation.

Plus précisément, la présente invention a pour objet un élément de mémoire tel que défini dans la revendication 1.

L'invention a également pour objet un registre à décalage utilisant une pluralité de tels éléments de mémoire, et un diviseur de fréquence réalisé à partir d'un tel élément de mémoire.

D'autres objets, caractéristiques et résultats de l'invention ressortiront de la description ci-après et des dessins qui s'y rapportent, où:

—la figure 1 représente schématiquement une vue de dessus d'un mode de réalisation de l'élément de mémoire selon l'invention;

—la figure 2, a à e, représente des diagrammes de signaux applicables à l'élément de mémoire précedent ou fournis par ce dernier;

—la figure 3, a à d, représente des schémas explicatifs du fonctionnement du dispositif de la figure 1;

—la figure 4 (a et b) représente le schéma et la caractéristique de transfert de l'un des éléments constitutifs du dispositif de la figure 1;

—la figure 5 représente une variante de réalisation de l'élément de mémoire selon l'invention;

—la figure 6 illustre le principe d'application de l'élément de mémoire selon l'invention à la réalisation d'un registre à décalage;

—la figure 7 est un premier mode de réalisation de la figure 6;

—la figure 8, a, b et c, représente des diagrammes de signaux applicables au dispositif de la figure 7;

—la figure 9 est un second mode de réalisation de la figure 6;

—la figure 10 illustre l'application de l'élément de mémoire selon l'invention à la division de fréquence;

—la figure 11, a à e, représente des signaux susceptibles d'être appliqués au dispositif de la figure 10, ou fournis par ce dernier.

Sur ces différentes figures, les mêmes références se rapportent aux mêmes éléments.

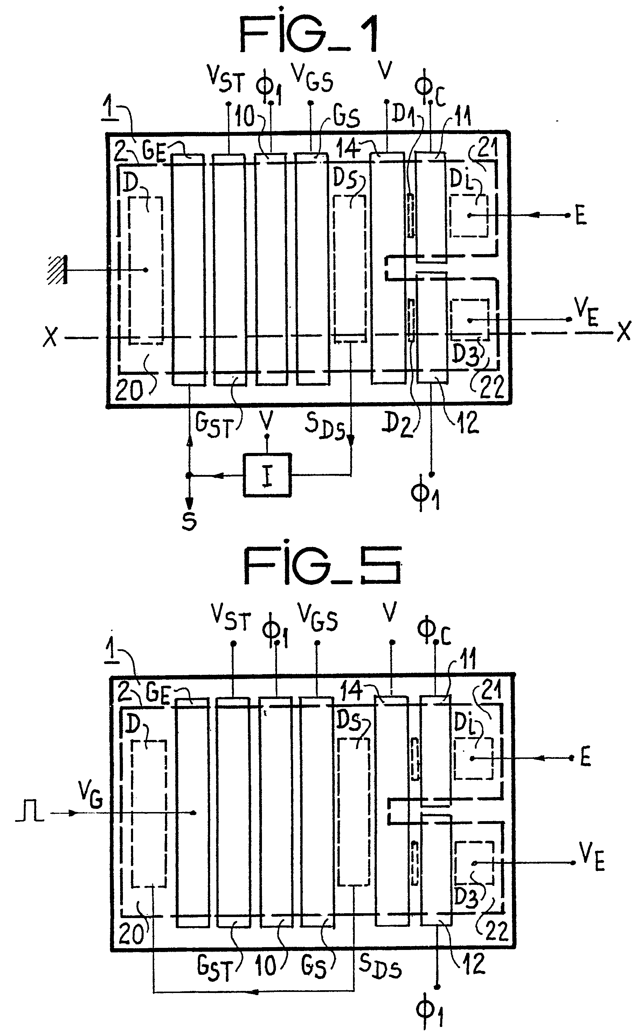

La figure 1 représente schématiquement, vu du dessus l'élément de mémoire selon l'invention.

Cet élément est constitué, comme il est classique pour les dispositifs à transfert de charges, par un substrat 1 semiconducteur (silicium par exemple) recouvert d'une couche d'isolant (oxyde de silicium par exemple), et d'électrodes placées sur la couche d'isolant. Cinq de ces électrodes, ou grilles, à savoir successivement $G_E$, $G_{ST}$, 10, $G_S$ et 14, sont disposées parallèlement les unes aux autres, perpendiculairement à la direction XX de transfert des charges dans le semiconducteur, et s'étendent sur toute la longueur du dispositif. A côté de l'électrode 14 sont placées deux demi-électrodes, 11 et 12. Dans le substrat semiconducteur 1, par exemple de type P, sont réalisées des diodes, par exemple par diffusion d'impuretés créant des zones de type N; ces diodes sont placées: la première (D), avant la grille $G_E$ et reliée au potentiel de référence du dispositif (masse); la seconde ($D_S$) entre les électrodes $G_S$ et 14; la troisième ($D_1$), entre les électrodes 14 et 11; la quatrième ($D_i$) après l'électrode 11; la cinquième ($D_2$) entre les électrodes 14 et 12, et enfin la sixième ($D_3$), après l'électrode 12. Dans le substrat 1 est réalisée, par tout moyen connu, une barrière d'isolement 2 qui a pour but de définir un canal 20 de transfert des charges entre la diode D et l'électrode 14, et deux demi-canaux parallèles 21 et 22. Ces deux derniers canaux sont issus de la séparation en deux parties du canal 20 sous l'électrode 14, le canal 21 correspondant aux diodes $D_1$, $D_i$ et l'électrode 11, et le canal 22 aux diodes $D_2$, $D_3$ et à l'électrode 12. Le dispositif comporte encore un élément I, inverseur et régénérateur, connecté entre la diode $D_S$ et la grille $G_E$.

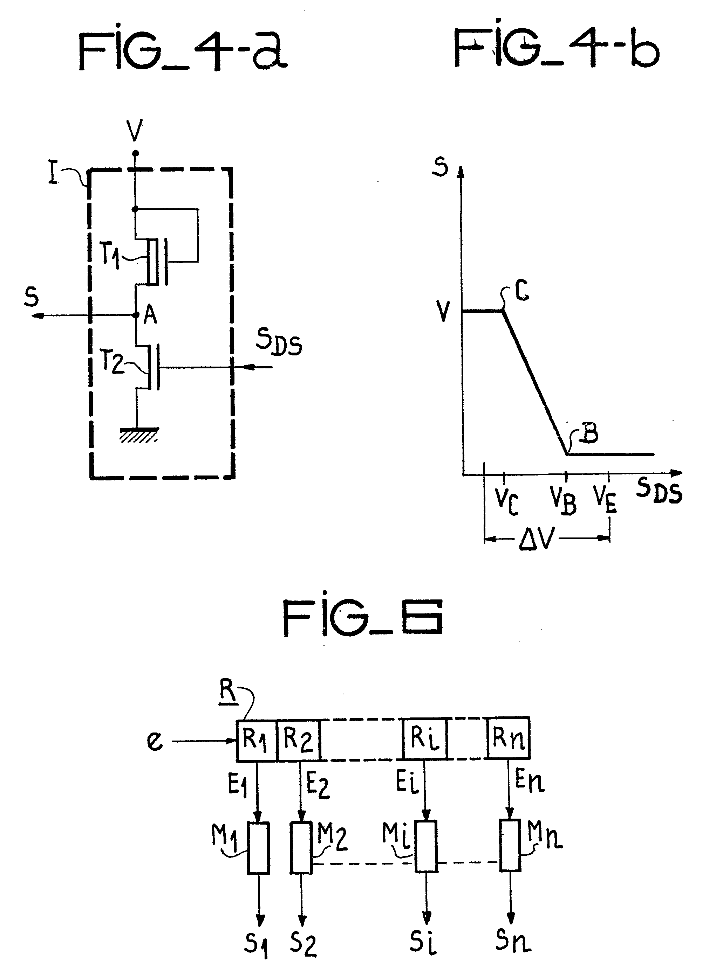

Un mode de réalisation de l'élément I est donné figure 4a.

Il est constitué de deux transistors de type MOS, $T_1$ et $T_2$, connectés en série entre le potentiel V et la masse. Il est à noter que le transistor $T_1$ est à déplétion et que tous les autres transistors illustrés tant sur la figure 4a que sur les figures suivantes sont à enrichissement, sauf indication contraire. La grille de $T_1$ est reliée au potentiel V alors que la grille de $T_2$ reçoit un signal $S_{DS}$ en provenance de la diode $D_S$. Au point commun A de ces deux transistors est disponible un signal S.

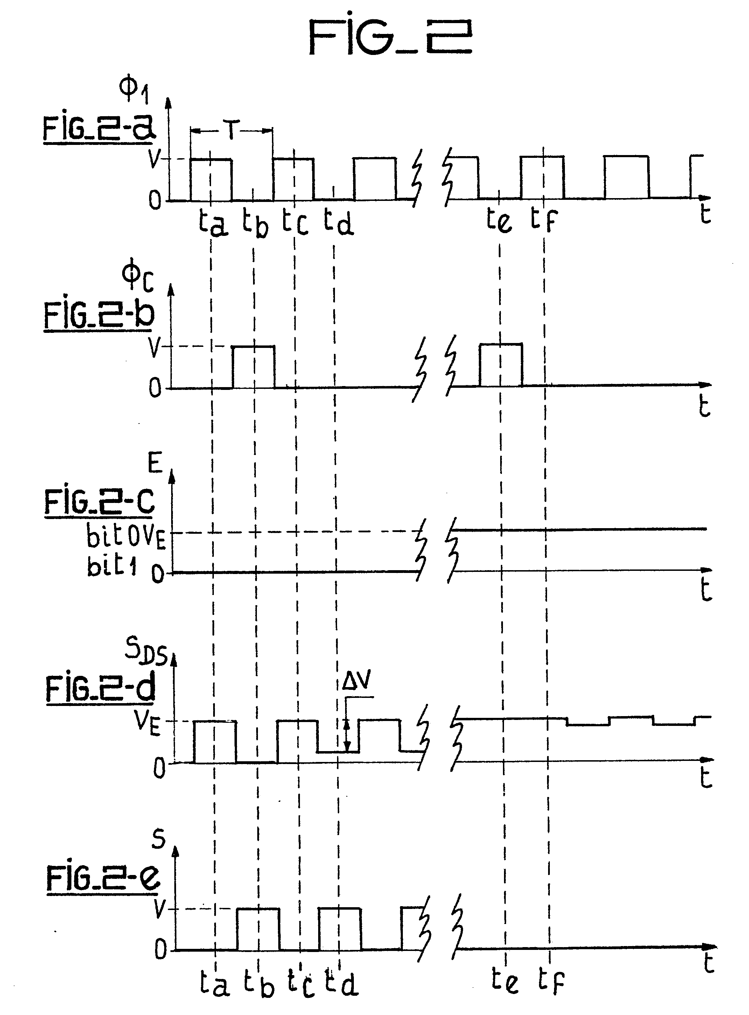

La figure 2 représente, en fonction du temps, des diagrammes (a à e) de signaux applicables au dispositif de la figure 1, ou fournis par lui.

Le diagramme 2a représente un potentiel $\phi_1$, dit potentiel de transfert, sensiblement en créneaux, de période T et dont l'amplitude varie entre 0 et V.

Le diagramme 2b représente un potentiel $\phi_C$, dit d'échantillonnage, qui n'est différent de zéro que lorsqu'on désire mémoriser le signal d'entrée, pendant une durée de T/2, lorsque $\phi_1$ est au niveau bas (zéro), avec une amplitude de préférence égale à V.

Le diagramme 2c représente un exemple de signal d'entrée binaire E appliqué au dispositif.

Le diagramme 2d représente le signal $S_{DS}$ fourni par la diode $D_S$ et alimentant l'inverseur I.

Le diagramme 2e représente le signal S fourni par l'inverseur I, qui d'une part constitue le signal de sortie du dispositif et d'autre part est appliqué à la grille $G_E$.

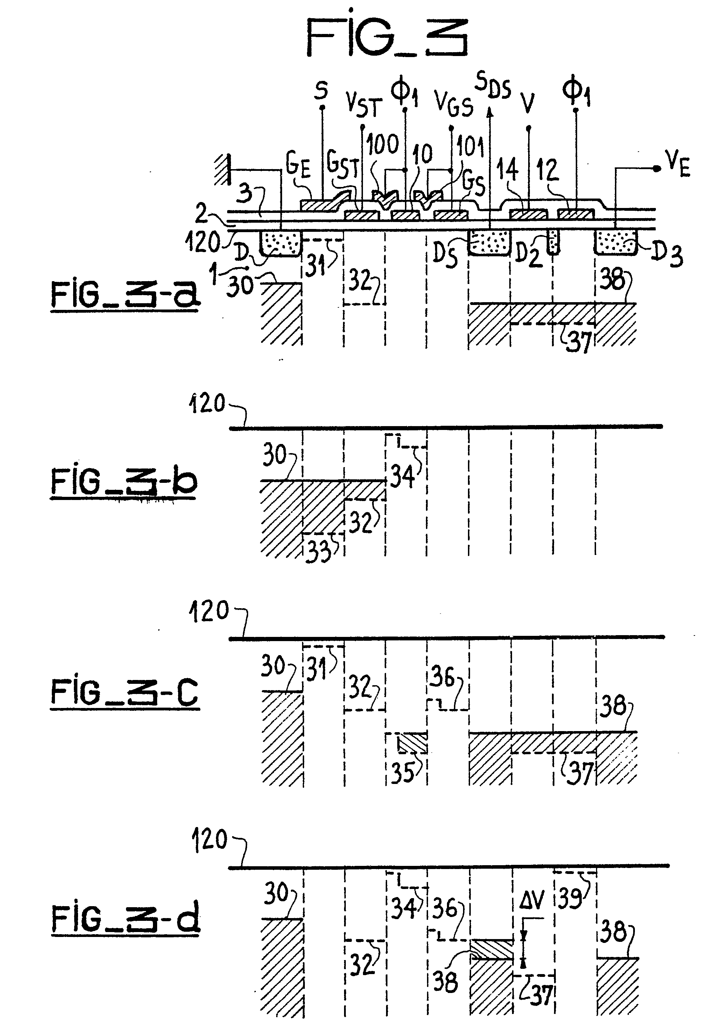

La figure 3, diagrammes a à d, illustre le fonctionnement du dispositif de la figure 1 à partir d'une coupe effectuée le long de l'axe XX de la figure 1.

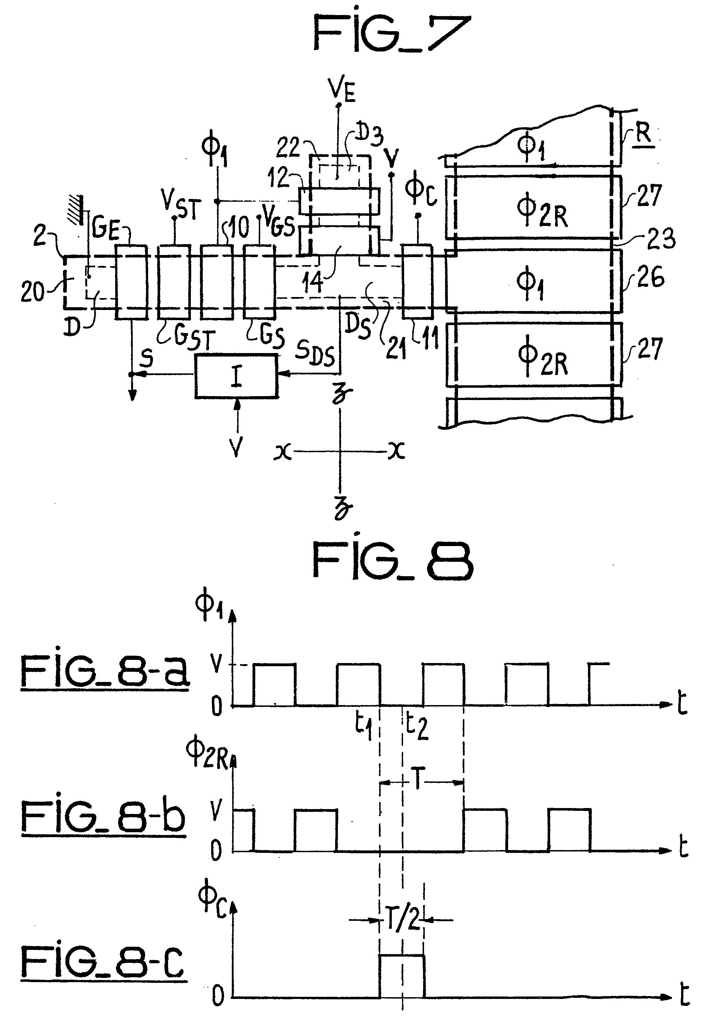

Sur la figure 3 est donc représenté le substrat semiconducteur 1, par exemple de type P, dans lequel sont diffusés des zones de type opposé (N) pour réaliser les diodes D, $D_S$, $D_2$ et $D_3$. Le substrat est recouvert uniformément d'une couche d'isolant 2, l'interface 1—2 étant repéré 120. Sur la couche d'isolant 2 est déposée une première série d'électrodes, à savoir les électrodes $G_{ST}$, 10, $G_S$, 12 et 14. La couche d'isolant 2 et les électrodes de la première série sont recouvertes d'une deuxième couche d'isolant (3) sur laquelle est déposée une seconde série d'électrodes, à savoir l'électrode $G_E$ ainsi que deux électrodes non représentées sur la figure 1: 100 et 101, placées respectivement entre les électrodes $G_{ST}$ et 10 d'une part, et 10 et $G_S$ d'autre part, et reliées électriquement respectivement aux électrodes 10 et $G_S$. Cette disposition des électrodes en deux séries, séparées du substrat semiconducteur par des épaisseurs d'isolant différentes, n'est pas représentée sur la figure 1, ainsi que sur les figures 5, 7, 9, et 10, afin de clarifier ces figures; le rôle de cette disposition est, ainsi qu'il est connu, d'une part de ne rendre possible le transfert des charges dans le semiconducteur que dans un seul sens et, d'autre part, éviter la formation de barrières de potentiel entre les électrodes adjacentes: en effet, les électrodes n'étant ici pas sur le même niveau, peuvent se recouvrir partiellement comme illustré sur la figure 3. De même, la diode $D_2$ entre les électrodes 12 et 14, comme la diode $D_1$ entre les électrodes 11 et 14 dans le canal 21, a pour fonction d'éviter la formation d'une barrière de potentiel entre ces deux électrodes.

Le fonctionnement de ce dispositif est le suivant:

A l'instant initial ta, illustré figure 2 et sur le diagramme (a) de la figure 3, le potentiel $\phi_C$ est au niveau bas, isolant la diode $D_S$ du signal d'entrée E, et le potentiel $\phi_1$ est au niveau haut (V), permettant par l'intermédiaire du canal 22 l'application d'un potentiel $V_E$, voisin du potentiel V, sur la diode $D_S$: en effet, la diode $D_3$ est reliée au potentiel $V_E$ (ligne 38) et l'électrode 12 (ligne pointillée 37 au droit de cette électrode) au potentiel $\phi_1$. L'inverseur I fournit donc un signal S nul. La diode D est par ailleurs reliée à la masse, ce niveau du potentiel étant illustré sur la figure 3a par une ligne 30 au droit de la diode D, et l'électrode $G_{ST}$ est maintenue à un potentiel positif constant $V_{ST}$ (ligne pointillée 32 au droit de l'électrode $G_{ST}$). Il apparaît sur la figure 3a que le signal S appliqué à la grille $G_E$ (ligne pointillée 31 au droit de cette dernière électrode) interdit l'injection des charges de la diode D vers le reste du dispositif.

A un instant ultérieur tb, illustré sur le diagramme b de la figure 3 où, pour simplifier, on n'a plus représenté que l'interface 120 et les niveaux de potentiel dans le substrat, le potentiel $\phi_C$ est au niveau haut (voir figure 2, instant tb), ce qui a pour effet de transmettre sur la diode $D_S$ la valeur du signal d'entrée E, reçu sur la diode $D_i$ (voir figure 1).

Ce signal E est un signal binaire, qui peut prendre deux valeurs, zéro et un la première (zéro) étant représentée par exemple, en logique négative, par un potentiel continu $V_E$ et la seconde (un) par le potentiel de référence (masse). Le signal E est transmis de la diode $D_i$ à la diode $D_S$ à condition que le potentiel constant appliqué sur l'électrode 14 soit suffisamment élevé; ce potentiel est de préférence égal à l'amplitude V. Si par exemple le signal d'entrée E est égal à un, représenté par un niveau de potentiel nul (figure 2c) à l'instant tb, le signal $S_{DS}$ est nul et l'inverseur I fournit un signal S non nul, égal à V, appliqué sur la grille $G_E$. Il apparaît sur le diagramme 3b que l'application du signal S sur la grille $G_E$, le niveau de potentiel correspondant étant illustré par une ligne pointillée 33 au droit de la grille $G_E$, permet l'injection d'un paquet de charges sous les grilles $G_E$ et $G_{ST}$, et seulement sous celles-ci, du fait que le potentiel $\phi_1$ est au niveau bas (ligne pointillée 34 sur la figure 3b, au droit de ces dernières électrodes).

Lorsqu'à un instant tc, représenté sur le diagramme (c) de la figure 3, le potentiel $\phi_1$ revient au niveau haut (ligne pointillée 35), les charges injectées précédemment sont alors transférées sous l'électrode 10, leur progression étant arrêtée là si, comme représenté sur la figure 3c, le potentiel $V_{GS}$ (ligne pontillée 36) auquel sont portées les électrodes suivantes (101 et $G_S$) est sensiblement inférieur au potentiel V. Le potentiel $V_{GS}$ peut être dans la pratique égal au potentiel $V_{ST}$. Durant cette phase tc, le potentiel $\phi_C$ est revenu au niveau bas, isolant la diode $D_S$ du signal d'entrée (canal 21), alors que, par le canal 22, cette même diode $D_S$ reçoit le potentiel $V_E$: en effet, la diode $D_3$ est reliée au potentiel constant $V_E$ et l'électrode 12 qui la sépare de la diode $D_S$ est reliée à $\phi_1$, alors au niveau haut (ligne 37). En conséquence, le signal $S_{DS}$ fourni par la diode $D_S$ est au niveau haut (ligne 38) et donc le signal S appliqué à la grille $G_E$, au niveau bas (ligne 31); cela a pour effet d'interdire toute nouvelle injection de charges.

A un instant ultérieur td, le potentiel $\phi_1$ revient au niveau bas (ligne 39), le potentiel $\phi_C$ est toujours au niveau bas et la diode $D_S$ se trouve donc isolée. Simultanément, le paquet de charges arrive à la diode $D_S$ après être passé sous les électrodes 101 et $G_S$, reliées au potentiel constant $V_{GS}$. Ce paquet de charges a pour effet une diminution du potentiel initial de $D_S$ (ligne 38) d'une quantité $\Delta V$, fonction de la quantité de charges, C'est cette grandeur $\Delta V$ qui conduit au choix de la valeur $V_E$: en effet $V_E$ doit être tel que la variation $\Delta V$ fasse basculer l'inverseur I, comme montré figure 4.

La figure 4b représente la caractéristique de transfert de l'inverseur I de la figure 4a.

Sur cette courbe, on voit que le signal S fourni par l'inverseur est à un niveau haut, sensiblement égal à V, lorsque le signal $S_{DS}$ qu'il reçoit est inférieur à un seuil $V_C$; que ce signal S est à un niveau bas (voisin de zéro) lorsque $S_{DS}$ est supérieur à un seuil $V_B$, et que S varie sensiblement continuement entre ces deux niveaux, d'un point C pour $S_{DS}=V_C$ à un point B pour $S_{DS}=V_B$ lorsque $S_{DS}$ augmente.

Selon ce qui précède, il faut donc choisir $V_E$ tel que la différence ($V_E-\Delta V$) soit supérieure à $V_C$ pour que l'inverseur I bascule, c'est-à-dire que son signal de sortie S passe du niveau bas au niveau haut. En pratique, on choisit $V_E$ voisin de mais supérieur à $V_B$.

En ce qui concerne l'ordre de grandeur des différents potentiels appliqués au dispositif, si l'amplitude V du potentiel $\phi_1$ est de l'ordre de 12 volts, le potentiel constant appliqué à l'électrode 14 est de préférence égal à 12 volts, les potentiels constants $V_{ST}$ et $V_{GS}$ étant plus faibles, par exemple de l'ordre de 5 volts.

A l'aide du dispositif décrit ci-dessus, il apparaît que lorsque le signal d'entrée E est au niveau bas (zéro volt), il est obtenu sur la diode $D_S$ un signal $S_{DS}$ sensiblement en créneaux de même période T que le potentiel $\phi_1$ qui, après régénération par l'inverseur I, fournit un signal de sortie S en créneaux, d'amplitude et de période égales à celles de $\phi_1$, déphasé de T/2 par rapport à $\phi_1$.

Lorsque le signal d'entrée E est au niveau haut ($V_E$) et que le potentiel $\phi_C$ passe au niveau haut (instant te sur la figure 2), un potentiel $V_E$ est transmis à la diode $D_S$ par le canal 21; le signal $S_{DS}$ est alors au niveau haut donc le signal S issu de l'inverseur au niveau bas. A l'instant suivant (tf sur la figure 2), le même potentiel $V_E$ est maintenu sur la diode $D_S$, mais alors par le canal 22, ce qui ne modifie ni le signal $S_{DS}$ (niveau haut) ni le signal S (niveau bas). On constate donc que le signal de sortie S est maintenu au niveau bas (zéro volt) tant que le signal d'entrée E est au niveau haut.

On a donc ainsi réalisé un élément de mémoire dynamique qui permet de conserver une information binaire (E au niveau haut ou au niveau bas). Cette information est disponible sur la sortie S avec une inversion, pendant le temps où le potentiel $\phi_1$ est au niveau bas.

Il est à noter que, dans la présente description, on a supposé que le substrat semiconducteur était de type P, les charges transférées étant des porteurs minoritaires (des électrons); il est bien entendu qu'un substrat de type N, où ce sont les trous qui se déplacent, est également-

ment utilisable à condition d'inverser la polarité de tous les potentiels appliqués.

Différentes variantes du dispostif décrit ci-dessus sont possibles et, parmi celles-ci, la suppression de l'électrode 14. En effet, celle-ci ne joue pas de rôle actif dans le transfert des charges. Toutefois il peut être préférable de la maintenir parce qu'elle joue un rôle d'écran entre la diode $D_S$ et l'électrode 12 qui reçoit le potentiel $\phi_1$: elle permet de limiter en amplitude les fluctuations du signal $S_{DS}$ dues à $\phi_1$, comme illustré sur la figure 2d après l'instant tf, évitant ainsi que l'inverseur I ne bascule.

Une autre variante de ce dispositif consiste à réaliser la fonction d'inversion non plus à l'aide d'un inverseur I extérieur tel que celui de la figure 4a, mais par une modification des signaux appliqués à l'étage d'injection, représentée figure 5.

La figure 5 est identique à la figure 1, sauf en ce qui concerne l'inverseur I qui est supprimé, la diode $D_S$ étant directement reliée à la diode D, et un signal $V_G$ qui est appliqué à la grille $G_E$: il s'agit d'un potentiel périodique qui est à un niveau haut, de préférence égal à V, pendant des instants brefs, inférieurs à T/2, pendant que le potentiel $\phi_1$ est lui-même bas.

En fonctionnement, comme précédemment, lorsque le signal d'entrée E est au niveau haut, le signal $S_{DS}$ reste au niveau haut, par l'intermédiaire soit du canal 21 soit du canal 22. Mais par ailleurs, on constate qu'avec de tels signaux appliqués, lorsque $S_{DS}$ et D sont au niveau haut, l'injection de charges est impossible, et donc le signal $S_{DS}$ reste au niveau haut, aucun paquet de charges ne venant diminuer le potentiel de la diode $D_S$ comme à l'instant td décrit plus haut.

Lorsque, au contraire, le signal d'entrée E est au niveau bas, comme précédemment le signal $S_{DS}$ revient au niveau bas lorsque $\phi_C$ est au niveau haut (instant tb). Dans le dispositif de la figure 5, l'injection de charges est alors possible et on obtient une évolution dans le temps du signal $S_{DS}$ en créneaux, analogue à celle qui est décrite pour le dispositif de la figure 1.

L'élément de mémoire de la figure 5 permet ainsi de conserver une information binaire qui est disponible sur la sortie $S_{DS}$ sans inversion, pendant le temps où le potentiel $\phi_1$ est au niveau bas.

La figure 6 illustre le principe d'application de l'élément de mémoire selon l'invention à la réalisation d'un registre à décalage, capable de fournir une information numérique de façon permanente sur une sortie du type parallèle.

On sait en effet qu'un registre à décalage utilisant la technique du transfert de charges est susceptible de distribuer une information du type série sur des sorties parallèles, mais qu'il ne peut pas assurer la conservation de cette information: en effet, l'agitation thermique dans le semiconducteur dégrade les puits de potentiels et conduit après un certain temps à la perte de l'information.

Pour pallier ce défaut, on dispose un élément de mémoire selon l'invention à la sortie de chaque sortie parallèle du registre à transfert de charges, comme représenté figure 6.

Sur cette figure, un signal d'entrée e, qui est une information binaire série, est appliqué à l'entrée d'un registre R à décalage, à n étages symbolisés par n cellules adjacentes, $R_1 \ldots R_i \ldots R_n$. La sortie $E_i$ de chaque cellule $R_i$ est reliée à un élément de mémoire $M_i$ tel que décrit ci-dessus. Chaque élément $M_i$ fournit de façon permanente, sur une sortie $S_i$, l'information binaire. L'ensemble des n sorties $S_i$ constitue la sortie parallèle permanente du dispositif.

La figure 7 représente un premier mode de réalisation pratique du schéma de la figure 6.

Sur cette figure, on a représenté un registre à décalage R à transfert de charges, constitué classiquement par un substrat semiconducteur recouvert d'isolant sur lequel sont déposées des électrodes, identiques et parallèles, auxquelles sont appliqués des potentiels périodiques donnés, par exemple $\phi_1$ pour les électrodes paires (26) et $\phi_{2R}$ pour les électrodes impaires (27). Pour simplifier le schéma, le registre R n'est représenté que par ses électrodes à l'intérieur desquelles est noté le potentiel appliqué. Selon un mécanisme classique, les charges électriques sont transférées d'un électrode à l'autre selon une direction ZZ normale aux électrodes 26 et 27, dans un canal limité par une barrière d'isolement 23.

La barrière d'isolement 23 est interrompue à chaque étage, c'est-à-dire par exemple au niveau de chaque électrode 26, pour la connexion d'un élément de mémoire selon l'invention. La connexion se fait par le canal 21 qui est dans le prolongement du canal 20, le canal 22 étant disposé perpendiculairement à ceux-ci.

L'élément de mémoire représenté est, dans cette figure comme les suivantes, à titre d'exemple celui décrit figure 1. Il peut être bien entendu remplacé par l'une quelconque de ses variantes. De plus, il n'est représenté ici, de façon simplifiée, que pour un seul étage.

L'élément de mémoire est donc identique à celui de la figure 1, à trois différences près:

— la suppression de la diode $D_i$ du canal 21, qui servait à l'injection du signal d'entrée E, puisque le signal d'entrée est maintenant constitué par un paquet de charges sous l'électrode 26;

— l'orientation du canal 22, qui devient normal à l'axe XX pour des considérations d'encombrement, ce qui modifie légèrement la forme de la diode $D_S$: elle est maintenant en forme de T afin de toujours relier les trois canaux 20, 21 et 22;

— l'électrode 14, reliée au potentiel V, qui ne s'étend plus que sur le canal 22: en effet, sa fonction étant, ainsi qu'il est dit plus haut, de constituer un écran entre la diode $D_S$ et le potentiel $\phi_1$ appliqué sur l'électrode 12 du canal 22, cette électrode 14 n'est vraiment nécessaire que sur ce dernier canal.

Le fonctionnement de ce dispositif sera expliqué à l'aide de la figure 8, qui représente les signaux $\phi_1$, $\phi_{2R}$ et $\phi_C$ qui lui sont appliqués.

Le signal $\phi_1$ représenté sur le diagramme (a) est identique à celui du diagramme 2(a).

Le signal $\phi_{2R}$ appliqué aux électrodes 27 du registre R est identique au signal $\phi_1$ mais en opposition de phase avec ce dernier, jusqu'à un instant $t_1$.

Avant l'instant $t_1$, les informations numériques sont injectées en série dans le registre R et les signaux $\phi_1$ et $\phi_{2R}$ assurent leur transfert jusqu'à ce que ces informations soient disposées sur l'ensemble du registre (à l'instant $t_1$).

Après l'instant $t_1$, qui intervient quand le potentiel $\phi_{2R}$ doit normalement remonter au niveau haut (V), celui-ci reste au niveau bas pendant toute une période (T). A cet instant $t_1$, le signal $\phi_C$ illustré sur le diagramme 8c passe au niveau haut pour une durée voisine de T/2.

A un instant $t_2$ suivant, les potentiels $\phi_1$ et $\phi_{2R}$ sont au niveau bas alors que $\phi_C$ est au niveau haut. Deux cas sont alors possibles:

— si des charges sont présentes sous l'électrode 26 du registre R, représentant une information binaire par exemple égale à zéro en logique négative, ces charges sont toutes transférées par l'action de $\phi_C$ et de $\phi_{2R}$ vers la diode $D_S$, ramenant ainsi le potentiel de $D_S$ vers zéro volt et, par suite, provoquant par l'intermédiaire de l'inverseur I l'injection d'un paquet de charges dans l'élément de mémoire. L'information est ainsi stockée et disponible sur la sortie S sous la forme illustrée sur le diagramme 2e;

— s'il n'y a pas de paquet de charges sous l'électrode 26 du registre R, cette absence représentant dans le même exemple de logique négative, une information binaire égale à un, la diode $D_S$ reste au niveau $V_E$; le signal S fourni par l'inverseur I est alors nul et il n'y a pas d'injection de paquet de charges dans l'élément de mémoire. Le niveau bas est alors conservé par l'élément de mémoire et disponible sur la sortie S.

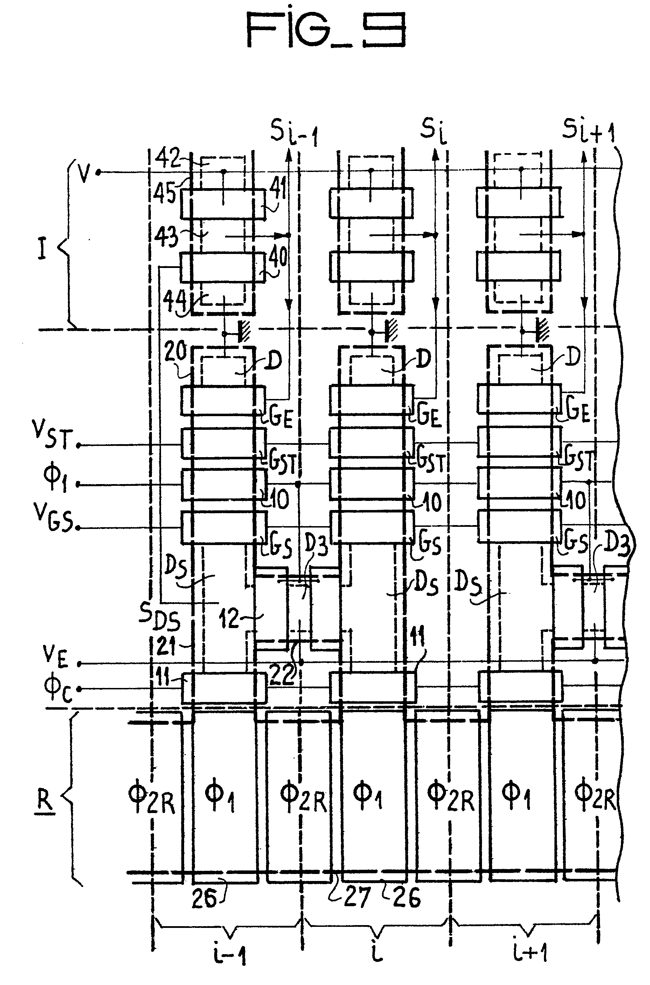

La figure 9 représente un autre mode de réalisation pratique du schéma de la figure 6, particulièrement compact.

Sur cette figure, comme sur la figure 7, on a représenté le registre à décalage R par ses électrodes 26 et 27, respectivement portées aux potentiels $\phi_1$ et $\phi_{2R}$. Chaque électrode 26, portée au potentiel $\phi_1$, définit un étage du registre R; trois de ces étages sont représentés sur la figure, respectivement i−1, i et i+1. A chaque électrode 26 est connecté un élément de mémoire selon l'invention, de façon analogue à ce qui est décrit sur la figure 7, c'est-à-dire par le canal 21 qui commence par l'électrode 11 reliée au potentiel $\phi_C$. Comme figure 7, le canal 20 est dans le prolongement du canal 21 et le canal 22 est parallèle au registre R. Toutefois, ce mode de réalisation diffère du précédent sur seux points:

— le canal 22, qui ne comporte pas d'électrode 14 et dont la diode $D_3$ est commune à deux étages adjacents (sur la figure 9, canaux i−1 et i);

— l'inverseur I qui est réalisé sur le même substrat que le registre R et les éléments de mémoire, dans le prolongement du canal 20.

L'inverseur I comporte trois zones 42, 43 et 44, d'un type de conductivité opposées à celles du substrat, entre lesquelles sont disposées, sur une couche isolante, deux électrodes, respectivement 41 et 40, qui constituent les grilles des transistors $T_1$ et $T_2$, de la figure 4a; la zone 44 est reliée à la masse, la zone 43 est le point commun A des deux transistors, sortie de l'inverseur et la zone 42 est portée au potentiel V. Ces différents éléments sont isolés du reste du substrat par une barrière d'isolement 45, analogue à la barrière 2 des figures précédentes.

Dans ce mode de réalisation, l'élément de mémoire dans sa quasi totalité est donc placé dans le prolongement de l'électrode 26 du registre R auquel il s'applique, sauf le canal 22 dont l'encombrement est réduit au maximum par la suppression de l'électrode 14 et la mise en commun de la diode $D_3$. Cette disposition permet l'application de l'élément de mémoire selon l'invention à un registre à décalage dont le pas, c'est-à-dire la distance entre le milieu de deux électrodes 26 consécutives, est faible. A titre d'exemple, il peut être de l'ordre de 40 $\mu$m.

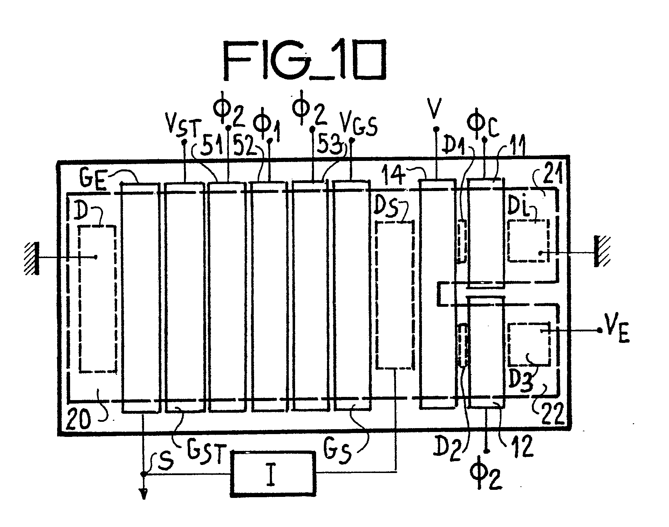

La figure 10 représente un mode de réalisation de l'application de l'élément de mémoire selon l'invention à la division de fréquence.

Le dispositif de la figure 10 est par exemple identique à celui de la figure 1, sauf en ce qui concerne les électrodes 10 et 12 et la diode $D_i$. L'électrode 10 de la figure 1 est en effet remplacée par trois électrodes parallèles 51, 52 et 53 recevant l'une (52) le potentiel $\phi_1$ et les deux autres (51 et 53) qui l'encadrent, un potentiel $\phi_2$. Le potentiel $\phi_2$ est de préférence identique au potentiel $\phi_1$, mais déphasé de T/2 par rapport à ce dernier. La diode $D_i$ est reliée en permanence à la masse.

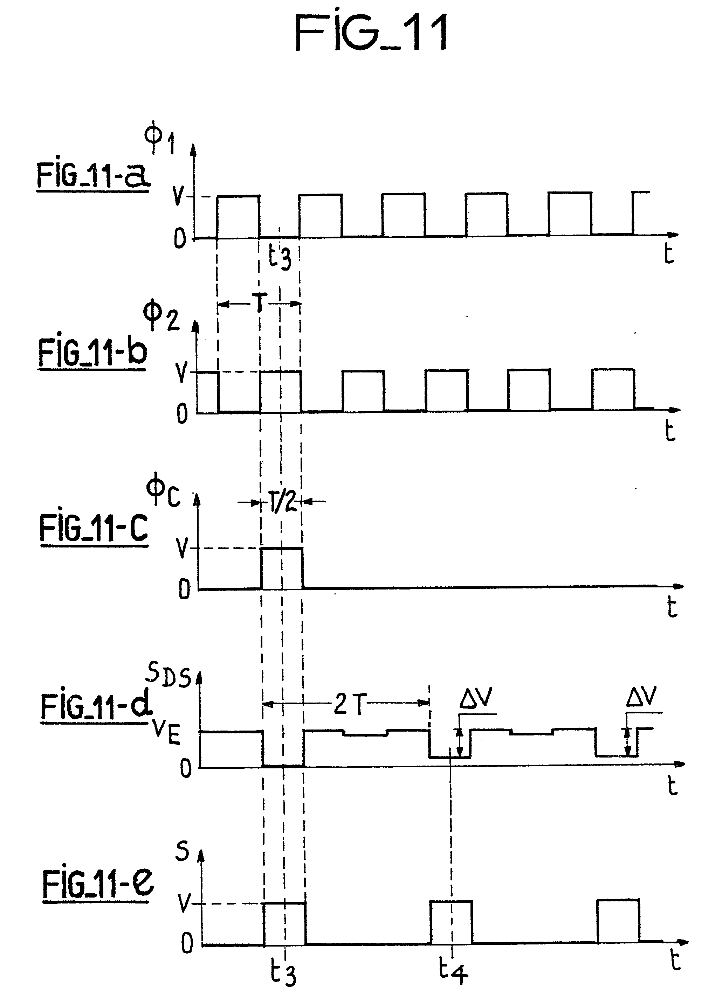

La figure 11, a, b, c, d et 3, représente des signaux susceptibles d'être appliqués au ou fournis par le dispositif de la figure 10.

Le diagramme (a) reprend la forme du potentiel $\phi_1$ de la figure 2a.

Le diagramme (b) représente le potentiel $\phi_2$, conforme à ce qui est dit ci-dessus.

Le diagramme (c) reprend la forme due potentiel $\phi_C$ de la figure 2b.

Les diagrammes (d) et (e) illustrent les signaux $S_{DS}$ et S fournis respectivement par la diode $D_S$ et l'inverseur I.

Le fonctionnement du dispositif de la figure 10 est le suivant:

Comme pour le dispositif de la figure 1, l'injection des charges s'effectue lorsque le potentiel $\phi_c$ est au niveau haut; à cet instant ($t_3$ sur la figure 11), un potentiel nul est appliqué sur la diode $D_S$ via le canal 21, le canal 22 étant fermé par le potentiel $\phi_2$ au niveau bas; le signal $S_{DS}$ étant nul, le signal S fourni par l'inverseur I est au niveau haut et, appliqué sur la grille $G_E$, autorise l'injection des charges dans le dispositif. Ce paquet de charges doit ensuite passer sous les électrodes 51, 52 et 53 et, du fait des potentiels appliqués sur ces électrodes, n'atteindra la diode $D_S$ qu'après un délai égal à 2T; à cet instant ($t_4$ sur la figure 11), il provoque un abaissement ($\Delta V$) du potentiel de la diode $D_S$ et, par suite, le passage du signal S au niveau haut, pendant une durée T/2.

Il apparaît donc que le signal S a une fréquence égale à 1/2T lorsqu'on place sur le canal 20 un couple supplémentaire d'électrodes reliées respectivement aux potentiels $\phi_1$ et $\phi_2$.

Plus généralement, le signal S a une fréquence divisée par (N+1) lorsqu'on place le canal 20 N couples supplémentaires d'électrodes reliées aux potentiels $\phi_1$ et $\phi_2$.

Dans une variante (non représentée) de ce dispositif, il peut être obtenu un signal retardé d'une demi période (T/2) par rapport au signal S en modifiant les potentiels appliqués aux électrodes 51, 52 et 53: c'est alors l'électrode 52 qui doit recevoir $\phi_2$, les deux autres recevant $\phi_1$.

**Revendications**

1. Elément de mémoire dynamique à transfert de charges, comportant un substrat semiconducteur dans lequel des charges électriques sont susceptibles d'être transférées à l'aide d'électrodes disposées sur le substrat, sensiblement parallèles les unes aux autres, et sur commande de potentiels périodiques appliqués à ces électrodes; cet élément de mémoire étant caractérisé par le fait qu'il comporte:

— disposés sur un premier canal (20) de transfert de charges, des premiers moyens (D, $G_E$, $G_{ST}$) d'échantillonnage et d'injection dans le substrat de paquets de charges représentant un signal électrique qui leur est appliqué;
— une diode dite diode de sortie ($D_S$), disposée sur le premier canal (20);
— disposés sur un deuxième canal (21) de transfert de charges, des deuxièmes moyens ($D_i$, 11) d'échantillonnage et d'injection dans le substrat de paquets de charges représentant le signal à mémoriser (E);
— disposés sur un troisième canal (22) de transfert de charges, des troisièmes moyens

($D_3$, 12) d'échantillonnage et d'injection dans le substrat de paquets de charges représentant un potentiel constant ($V_E$); que les canaux (20, 21, 22) sont disposés et commandés de telle sorte que les paquets de charges élaborés dans le troisième (22) canal n'atteignent la diode de sortie ($D_S$) que lorsque ceux qui sont élaborés dans le deuxième (21) canal ne l'atteignent pas, et que les paquets de charges élaborés dans le premier canal (20) rejoignent la diode de sortie ($D_S$) avec un retard défini par rapport à leur instant d'injection;

et que ledit élément de mémoire comporte en outre des moyens (I) d'inversion et de régénération, recevant le signal ($S_{DS}$) fourni par la diode de sortie ($D_S$) et coopérant avec les premiers moyens afin que soient injectés dans le substrat des paquets de charges représentant le signal ($S_{DS}$) fourni par la diode de sortie inversé et régénéré.

2. Elément de mémoire selon la revendication 1, caractérisé par le fait que les deuxièmes moyens d'échantillonnage et d'injection comportent une diode ($D_i$) à laquelle est appliqué le signal à mémoriser (E) et une électrode (11) à laquelle est appliqué un potentiel d'échantillonnage ($\phi_c$), assurant l'échantillonnage et l'application du signal à mémoriser (E) à la diode de sortie ($D_S$).

3. Elément de mémoire selon la revendication 2, caractérisé par le fait que les troisièmes moyens d'échantillonnage et d'injection comportent une diode ($D_3$) à laquelle est appliqué le potentiel constant ($V_E$) et une électrode (12) à laquelle est appliqué un potentiel périodique de transfert ($\phi_1$) tel que ledit potentiel constant ($V_E$) soit appliqué à la diode de sortie ($D_S$) lorsque le signal à mémoriser (E) ne l'est pas.

4. Elément de mémoire selon l'une des revendications précédentes, caractérisé par le fait que les premiers moyens d'échantillonnage et d'injection comportent une diode (D) et deux électrodes ($G_E$ et $G_{ST}$), la diode (D) étant maintenue à un deuxième potentiel constant (masse), la première électrode ($G_E$) recevant le signal (S) issu des moyens (I) d'inversion et de régénération, et la seconde électrode ($G_{ST}$) étant portée à un troisième potentiel constant ($V_{ST}$) supérieur au deuxième.

5. Elément de mémoire selon l'une des revendications précédentes, caractérisé par le fait que lesdits moyens (I) d'inversion et de régénération comportent deux transistors ($T_1$, $T_2$) du type MOS reliés en série entre la masse et un potentiel constant (V), la grille du transistor ($T_2$) relié à la masse recevant le signal ($S_{DS}$) issu de la diode de sortie ($D_S$), et la grille du second transistor ($T_1$) étant reliée au potentiel constant (V).

6. Elément de mémoire selon l'une des revendications 1 à 3, caractérisé par le fait que les moyens d'injection, d'inversion et de régénération comportent une diode (D) et deux électrodes ($G_E$; $G_S$), cette dernière diode (D) recevant le signal ($S_{DS}$) issu de la diode de sortie ($D_S$), la seconde électrode ($G_{ST}$) étant maintenue à un potentiel constant ($V_{ST}$) dont l'amplitude est comprise entre les valeurs minimale et maximale de l'amplitude dudit signal ($S_{DS}$) issu de la diode de sortie ($D_S$), la première électrode ($G_E$) recevant un potentiel périodique ($V_p$) n'autorisant que périodiquement l'injection de paquets de charges représentant ledit signal ($S_{DS}$) issu de la diode de sortie ($D_S$).

7. Elément de mémoire selon la revendication 1, caractérisé par le fait qu'il comporte de plus une électrode (14) adjacente à la diode de sortie ($D_S$) s'étendant au moins sur le second canal (21), portée à un potentiel constant (V) égal ou supérieur à l'amplitude maximale du signal ($S_{DS}$) fourni par la diode de sortie ($D_S$).

8. Elément de mémoire selon la revendication 1, caractérisé par le fait que le premier canal (20) comporte, après les premiers moyens, une électrode (10) reliée à un potentiel de transfert ($\phi_1$).

9. Registre à décalage à transfert de charges, comportant une entrée recevant un signal (e) du type série, et une pluralité (n) d'étages ($R_1 \ldots R_n$), caractérisé par le fait qu'il comporte de plus une pluralité (n) d'éléments de mémoire ($M_1 \ldots M_n$) selon l'une des revendications précédentes, la sortie de chacun des étages du registre étant reliée à l'entrée ($E_1 \ldots E_n$) de l'un des éléments constituant une sortie de type parallèle du registre.

10. Registre selon la revendication 9, caractérisé par le fait que les premier (20) et second (21) canaux sont placés normalement à la direction (ZZ) de transfert des charges dans les étages du registre (R), et que le troisième canal (22) est placé parallèlement à cette même direction (ZZ).

11. Registre selon la revendication 3 et l'une des revendications 9 ou 10, caractérisé par le fait que des éléments de mémoire adjacents, pris deux par deux, ont en commun la diode ($D_3$) du troisième canal (22).

12. Diviseur de fréquence fournissant un signal dont la fréquence est divisée par (N+1) par rapport à un signal de période (T) donnée, comportant un élément de mémoire selon l'une des revendications 1 à 7, caractérisé par le fait que le premier canal (20) comporte, après les premiers moyens, N couples d'électrodes, les électrodes de chaque couple étant reliées respectivement audit signal de période (T) mais déphasé par rapport au précédent d'une demi-période (T/2).

## Patentansprüche

1. Dynamisches Speicherelement mit Ladungstransfer, das ein halbleitendes Substrat enthält, in dem elektrische Ladungen mithilfe von auf dem Substrat angebrachten und im wesentlichen zueinander parallelen Elektroden und unter Steuerung durch periodisch an diese Elektroden angelegte Potentiale übertragen werden können, dadurch gekennzeichnet, daß das Speicherelement aufweist:

— erste auf einem ersten Ladungstransferkanal (20) angeordnet Mittel (D, $G_E$, $G_{ST}$) zur Abtastung und zur Injektion in das Substrat von Ladungspaketen, die einem elektrischen Signal entsprechen, das an die Mittel angelegt wird,
— eine Ausgangsdiode genannte Diode ($D_S$), die auf dem ersten Kanal (20) angeordnet ist,
— zweite auf einem zweiten Ladungstransferkanal (21) angeordnete Mittel ($D_I$, 11) zur Abtastung und zur Injektion in das Substrat von Ladungspaketen, die einem zu speichernden Signal (E) entsprechen,
— dritte auf einem dritten Ladungstransferkanal (22) angeordnete Mittel ($D_3$, 12) zur Abtastung und zur Injektion in das Substrat von Ladungspaketen, die einem konstanten Potential ($V_E$) entsprechen,

daß die Kanäle (20, 21, 22) derart angeordnet und gesteuert sind, daß die im dritten Kanal (22) erarbeiteten Ladungspakete die Ausgangsdiode ($D_S$) nur erreichen, wenn die Ladungspakete, die im zweiten Kanal (21) erarbeitet werden, diese nicht erreichen, und daß die im ersten Kanal (20) erarbeiteten Ladungspakete die Ausgangsdiode ($D_S$) mit einer definierten Verzögerung bezüglich ihres Injektionszeitpunkts erreichen, und daß das Speicherelement außerdem Mittel (I) zur Inversion und Regeneration aufweisen, die das von der Ausgangsdiode ($D_S$) gelieferte Signal ($S_{DS}$) zugeführt erhalten und mit den ersten Mitteln so zusammenwirken, daß in das Substrat Ladungspakete injiziert werden, die dem von der Ausgangsdiode gelieferten Signal ($S_{DS}$) nach dessen Inversion und Regeneration entsprechen.

2. Speicherelement nach Anspruch 1, dadurch gekennzeichnet, daß die zweiten Abtast- und Injektionsmittel eine Diode ($D_I$), an die das zu speichernde Signal (E) angelegt wird, und eine Elektrode (11) aufweisen, an die ein Abtastpotential ($\phi_C$) angelegt ist, mit der die Abtastung und die Weitergabe des zu speichernden Signals (E) an die Ausgangsdiode ($D_S$) bewirkt wird.

3. Speicherelement nach Anspruch 2, dadurch gekennzeichnet, daß die dritten Abtast- und Injektionsmittel eine Diode ($D_3$), an die das konstante Potential ($V_E$) angelegt ist, und eine Elektrode (12) aufweisen, an die ein solches periodisches Transferpotential ($\phi_1$) angeleft ist, daß das konstante Potential ($V_E$) an die Ausgangsdiode ($D_S$) gelangt, wenn das zu speichernde Signal (E) nicht an die Ausgangsdiode gelangt.

4. Speicherelement nach einem der vorhergehenden Ansprüche, dadurch gekennzeichnet, daß die ersten Abtast- und Injektionsmittel eine Diode (D) und zwei Elektroden ($G_E$ und $G_{ST}$) aufweisen, von denen die Diode (D) auf einem zweiten konstanten Potential (Masse) gehalten wird, die erste Elektrode ($G_E$) das von den Inversions- und Regenerationsmitteln I) stammende Signal (S) empfängt und die zweite Elektrode ($G_{ST}$) auf ein drittes konstantes Potential ($V_{ST}$) gebracht ist, das über dem zweiten liegt.

5. Speicherelement nach einem der vorhergehenden Ansprüche, dadurch gekennzeichnet, daß die Inversions- und Regenerationsmittel (I) zwei Transistoren (T1, T2), von MOS-Typ enthalten, die in Reihe zwischen Masse und einem konstanten Potential angeordnet sind, wobei der Steueranschluß des mit Masse verbundenen Transistors ($T_2$) das von der Ausgangsdiode ($D_S$) stammende Signal ($S_{DS}$) und der Steueranschluß des anderen Transistors ($T_1$) das konstante Potential (V) empfängt.

6. Speicherelement nach einem der Ansprüche 1 bis 3, dadurch gekennzeichnet, daß die Injektions-, die Inversions- und Regenerationsmittel eine Diode (D) und zwei Elektroden ($G_E$; $G_S$) aufweisen, wobei diese Diode (D) das von der Ausgangsdiode ($D_S$) stammende Signal ($S_{DS}$) empfängt, die zweite Elektrode ($G_{ST}$) auf einem konstanten Potential ($V_{ST}$) gehalten wird, dessen Amplitude zwischen dem Mindest- und dem Höchstwert der Amplitude des von der Ausgangsdiode ($D_S$) gelieferten Signals liegt, und die erste Elektrode ($G_E$) ein periodisches Potential ($V_D$) zugeführt erhält, das nur periodisch die Injizierung von Ladungspaketen entsprechend dem von der Ausgangsdiode ($D_S$) gelieferten Signal ($S_{DS}$) zuläßt.

7. Speicherelement nach Anspruch 1, dadurch gekennzeichnet, daß es außerdem eine der Ausgangsdiode ($D_S$) benachbarte Elektrode (14) aufweist, die sich mindestens über den zweiten Kanal (21) erstreckt und auf eine konstantes Potential (V) gebracht ist, das gleich hoch oder höher als die Höchstamplitude des von der Ausgangsdiode ($D_S$) gelieferten Signals ($S_{DS}$) ist.

8. Speicherelement nach Anspruch 1, dadurch gekennzeichnet, daß der erste Kanal (20) hinter den ersten Mitteln eine an ein Transferpotential ($\phi_1$) angelegte Elektrode (10) aufweist.

9. Schieberegister mit Ladungstransfer, das einen ein Signal (e) vom Serientyp empfangenden Eingang und eine Vielzahl (n) von Stufen ($R_1 \ldots R_n$) aufweist, dadurch gekennzeichnet, daß es außerdem eine Vielzahl (n) von Speicherelementen ($M_1 \ldots M_n$) nach einem der vorhergehenden Ansprüche enthält, wobei der Ausgang jeder Registerstufe an den Eingang ($E_1 \ldots E_n$) eines der Elemente angeschlossen ist und einen Parrallelausgang des Registers bildet.

10. Register nach Anspruch 9, dadurch gekennzeichnet, daß der erste (20) und der zweite Kanal (21) senkrecht zur Richtung (ZZ) des Ladungstransfers in den Stufen des Registers (R) verlaufen und daß der dritte Kanal (22) parallel zu dieser Richtung (ZZ) verläuft.

11. Register nach Anspruch 3 und einem der Ansprüche 9 oder 10, dadurch gekennzeichnet, daß benachbarte Speicherelemente paarweise die Diode ($D_3$) des dritten Kanals (22) gemein haben.

12. Frequenzteiler, der ein Signal einer durch (N+1) bezüglich eines Signals gegebener Periode (T) geteilten Frequenz liefert, mit einem Speicherelement gemäß einem der Ansprüche 1 bis 7, dadurch gekennzeichnet, daß der erste Kanal (20) hinter den ersten Mitteln N Elektrodenpaare aufweist, wobei die Elektroden jedes Paares mit dem Signal der Periode T, aber mit einer Phasenverschiebung von einer Halbperiode (T/2) bezüglich des vorhergehenden Paares gespeist werden.

**Claims**

1. A dynamic memory element of the charge transfer type, comprising a semiconductor substrate in which electric charges can be transferred by means of electrodes disposed on the substrate, these electrodes being substantially parallel one to the other and being submitted to periodical control potentials which are applied to these electrodes, characterized in that the memory element comprises:

— first means (D, $G_E$, $G_{ST}$) for sampling and injecting packs of charges representing an applied electric signal into the substrate, these means being disposed on a first charge transfer channel (20),
— a diode called output diode ($D_S$) disposed on the first channel (20),
— second means ($D_I$, 11) for sampling and injecting packs of charges representing the signal (E) to be stored in the substrate, these means being disposed on a second charge transfer channel (21),
— third means ($D_3$, 12) for sampling and injecting packs of charges representing a constant potential ($V_E$) into the substrate, these means being disposed on a third charge transfer channel (22),

that the channels (20, 21, 22) are disposed and controlled in such a way that the packs of charges elaborated in the third channel (22) only reach the output diode ($D_S$), if the packs of charges elaborated in the second channel (21) do not reach this diode, and that the packs of charges elaborated in the first channel (20) arrive at the output diode ($D_S$) after a particular delay with respect to their injection moment, and that said memory element moreover comprises inversion and regeneration means (I) receiving the signal ($S_{DS}$) which is furnished by the output diode ($D_S$), and co-operating with the first means in order that packs of charges are injected representing the inverted and regenerated signal ($S_{DS}$) which is furnished by the output diode.

2. A memory element according to claim 1, characterized in that the second sampling and injection means comprise a diode ($D_I$) to which the signal (E) is applied which is to be stored, and an electrode (11) to which a sampling potential ($\phi_C$) is applied and which ensures the sampling and the application of the signal (E) which is to be stored, to the output diode ($D_S$).

3. A memory element according to claim 2, characterized in that the third sampling and injection means comprise a diode ($D_3$) to which the constant potential ($V_E$) is applied, and an electrode (12) to which such a periodical transfer potential ($\phi_1$) is applied, that said constant potential ($V_E$) is applied to the output diode ($D_S$) if the signal (E) which is to be stored is not applied thereto.

4. A memory element according one of the preceding claims, characterized in that the first sampling and injection means comprise a diode (D) and two electrodes ($G_E$ and $G_{ST}$), the diode (D) being kept at a second constant potential (earth), the first electrode ($G_E$) receiving the output signal (S) of the inversion and regeneration means (I), and the second electrode ($G_{ST}$) being brought to a third constant potential ($V_{ST}$) higher than the second.

5. A memory element according to one of the preceding claims, characterized in that said inversion and regeneration means (I) comprise two transistors ($T_1$, $T_2$) of the MOS type which are connected in series configuration between the earth and a constant potential (V), the grid of the transistor ($T_2$) which is connected to earth receiving the output signal ($S_{DS}$) of the output diode ($D_S$), and the grid of the second transistor ($T_1$) being connected to the constant potential (V).

6. A memory element according to one of the claims 1 to 3, characterized in that the injection, inversion and regeneration means comprise a diode (D) and two electrodes ($G_E$; $G_S$), said diode (D) receiving the output signal ($S_{DS}$) of the output diode ($D_S$), the second electrode ($G_{ST}$) being kept at a constant potential ($V_{ST}$), the amplitude of which is included between the minimum and the maximum amplitude value of this signal ($S_{DS}$) issued by the output diode ($D_S$), the first electrode ($G_E$) receiving a periodical potential ($V_D$) which allows only periodically the injection of packs of charges which represent the output signal ($S_{DS}$) of the output diode ($D_S$).

7. A memory element according to claim 1, characterized in that it comprises moreover an electrode (14) which is adjacent to the output diode ($D_S$), which extends at least over the second channel (21) and which is brought to a constant potential (V), this potential being equal to or higher than the maximum amplitude of the output signal ($S_{DS}$) of the output diode ($D_S$).

8. A memory element according to claim 1, characterized in that the first channel (20) comprises after the first means an electrode (10) which is connected to a transfer potential ($\phi_1$).

9. A shift register of the charge transfer type comprising an input which receives series type signal (e) and a plurality (n) of stages ($R_1 \ldots R_n$), characterized in that it comprises moreover a plurality (n) of memory elements ($M_1 \ldots M_n$) according to one of the preceding claims, the output of each register stage being connected to the input ($E_1 \ldots E_n$) of one of the elements and constituting a parallel type output of the register.

10. A register according to claim 9, characterized in that the first (20) and second channels (21) are disposed perpendicularly to the charge transfer direction (ZZ) in the register (R) stages and that the third channel (22) is disposed parallelly to this very direction (ZZ).

11. A register according to claim 3 and to one of the claims 9 or 10, characterized in that the adjacent memory elements are provided two by two with a common diode ($D_3$) of the third channel (22).

12. A frequency divider furnishing a signal the frequency of which is divided by (N+1) with respect to a signal of a given period (T), comprising a memory element according to one of the claims 1 to 7, characterized in that the first channel (20) comprises after the first means N pairs of electrodes, the electrodes of each pair being connected respectively to said signal of the period T but phase shifted with respect to the preceding pair by half a period (T/2).

# FIG_1

# FIG_5

0 009 438

FIG_2

# FIG_3

FIG_3-a

FIG_3-b

FIG_3-c

FIG_3-d

# FIG_4-a

# FIG_4-b

# FIG_6

# FIG_7

# FIG_8

## FIG_8-a

## FIG_8-b

## FIG_8-c

FIG_9

0 009 438

6

# FIG_1□

# FIG_11

FIG_11-a

FIG_11-b

FIG_11-C

FIG_11-d

FIG_11-e